# EUROPEAN PATENT SPECIFICATION

(11) **EP 4 081 864 B1**
(45) Date of publication and mention of the grant of the patent: **23.04.2025**
(21) Application number: 20906261.1
(22) Date of filing: 09.12.2020
(51) Int. Cl.: G03F 7/20, G03F 1/66, H01L 21/673

(54) **RETICLE POD HAVING RETENTION THROUGH BASEPLATE**
MASKENHALTER MIT HALTERUNG DURCH GRUNDPLATTE
NACELLE DE RÉTICULE À RÉTENTION PAR PLAQUE DE BASE

(30) Priority: 24.12.2019 US 201962953326 P
(43) Date of publication of application: 02.11.2022
(60) Divisional application: 25160889.9
(73) Proprietor: Entegris, Inc., Billerica, MA 01821 (US)
(72) Inventor: RASCHKE, Russ V., Chanhassen, Minnesota 55317 (US)
(74) Representative: Greaves Brewster LLP
(86) International application number: PCT/US2020/064063
(87) International publication number: WO 2021/133553

(56) References cited:
- EP-A2- 0 522 865
- EP-A2- 0 522 865
- US-A1- 2009 027 639
- US-A1- 2012 037 522
- US-A1- 2012 037 522
- US-A1- 2012 175 279
- US-A1- 2012 175 279
- US-A1- 2013 020 220
- US-A1- 2013 248 399

## Description

### Cross-Reference to Related Application

This application claims the benefit of and priority to U.S. Provisional Application No. 62/953,326, filed on December 24, 2019.

### Technical Field

This disclosure is directed to reticle pods and more particularly, to reticle pods including movable reticle retention features for retaining a reticle at a desired position.

### Background

Reticle pods are used for storage and transport of reticles as well as processing, particularly transport of reticles to and from processing tools such as photolithography devices. Reticle pods include, for example, Extreme Ultraviolet (EUV) pods for use with EUV photolithography tools. Reticle pods are constructed to reduce and/or prevent contamination or physical damage to the reticles contained therein during movement, handling, and processing of the reticles. Reticle pods may include an outer pod and an inner pod within the outer pod. The inner pod may include a baseplate and a cover, which contain the reticle. The outer pod includes a pod door and a pod dome, which contains the inner pod.

The following document is cited as being a pertinent prior art illustration:
US2012037522 describes a reticle pod comprising a container body and a container base, and a first inner space being formed between the container body and the container base for storing an inner container.

The following documents are also mentioned as a complementary prior art illustration:
US2012175279
EP0522865
US2013248399

### Summary

This disclosure is directed to reticle pods including movable retention features for retaining the reticle located on the baseplate.

Movable retention features allow a reticle to be securely positioned within a reticle pod, and thus less susceptible to shocks during handling or transit. By actuating such features through latches located in a door of the reticle pod, the reticle may be properly placed within the pod without interference from security features prior to final closure of the reticle pod, and secured when the pod is closed for transport, storage, or processing. Securing the reticle may limit or prevent damage to the reticle including shock incidents, particle generation from contact of the reticle and the interior of the pod, and the like.

A reticle pod embodiment includes an inner portion including a cover and a baseplate. The cover includes one or more cover reticle contacts joined to the cover and the baseplate includes one or more movable reticle contacts, the one or more movable reticle contacts each configured to be movable in a direction having a component perpendicular to the plane of the baseplate. The reticle pod includes an outer portion comprising a pod dome and a pod door, wherein the pod door includes one or more movable posts and one or more latches configured to drive the one or more movable posts. When the inner portion is located within the outer portion and the pod door is fixed to the pod dome, the one or more movable posts contact the one or more movable reticle contacts such that the one or more movable reticle contacts are moved towards the cover.

In an embodiment, each of the one or more movable reticle contacts are retained in the baseplate via a flexible member.

In an embodiment, when the flexible member is at rest, the movable reticle contact is at a distance from at least one of the one or more cover reticle contacts that is greater than a thickness of a reticle to be stored in the reticle pod.

In an embodiment, the one or more latches are each movable in a direction in plane with pod door.

In an embodiment, the one or more latches each include a sliding surface, a rocker arm, or a camming surface in contact with a surface of one of the one or more movable posts.

In an embodiment, the one or more movable reticle contacts are each configured to be movable in a direction perpendicular to the plane of the baseplate.

In an embodiment, the pod dome includes one or more projections that contact the cover when the inner portion is located within the outer portion and the pod door is fixed to the pod dome.

In an embodiment, each of the cover reticle contacts includes a polymer material.

In an embodiment, each of the movable reticle contacts includes a polymer material.

In an embodiment, the one or more movable reticle contacts includes three or more movable reticle contacts.

In an embodiment, the one or more movable reticle contacts includes four movable reticle contacts.

In an embodiment, each of the one or more movable reticle contacts is opposite one of the one or more cover reticle contacts when the cover and the baseplate are connected to one another.

In an embodiment, each of the one or more movable reticle contacts are offset from the one or more cover reticle contacts when the cover and the baseplate are connected to one another.

In an embodiment, each of the one or more movable reticle contacts is at a position corresponding to a comer of a reticle.

In an embodiment, a method of moving contacts within a pod includes activating one or more latches located in a pod door by attaching the pod door to a pod dome and driving, via the one or more latches, one or more movable posts to extend in a direction having a component perpendicular to a plane of the pod door. Each of the one or more movable posts contacts a movable reticle contact of a baseplate located within the pod door and the pod dome, such that the movable reticle contact moves in a direction having a component perpendicular to the plane of the baseplate and towards a cover located within the pod door and the pod dome.

In an embodiment, activating the one or more latches comprises moving the one or more latches in one or more directions that are parallel to a plane of the pod door.

In an embodiment, driving, via the one or more latch, the movable post comprises a camming surface on each of the one or more latches contacting one of the one or more movable posts.

In an embodiment, the method further includes further comprising placing the reticle on a baseplate of the pod, joining the baseplate of the pod to a cover of the pod, and placing the joined baseplate and cover into a space within the pod dome. In an embodiment, the joined baseplate and cover are in contact with one or more projections from the pod dome when placed within the pod dome.

In an embodiment, at least three movable posts are driven via the one or more latches

In an embodiment, the cover includes one or more cover reticle contacts, each of the cover reticle contacts opposite one of the movable reticle contacts.

In an embodiment, the cover includes one or more cover reticle contacts, each of the cover reticle contacts offset from the movable reticle contacts.

In an embodiment, a reticle pod includes an inner portion comprising a cover and a baseplate. The cover includes one or more cover reticle contacts joined to the cover and the baseplate includes one or more apertures. The reticle pod includes an outer portion comprising a pod dome and a pod door. The pod door includes one or more movable posts and one or more latches configured to drive the one or more movable posts. When the inner portion is located within the outer portion and the pod door is fixed to the pod dome, the one or more movable posts extend through the one or more apertures into the inner portion.

In an embodiment, the one or more latches are each movable in a direction in plane with pod door.

In an embodiment, the one or more latches each include a sliding surface, a rocker arm, or a camming surface in contact with a surface of one of the one or more movable posts.

In an embodiment, the pod dome includes one or more projections that contact the cover when the inner portion is located within the outer portion and the pod door is fixed to the pod dome.

In an embodiment, each of the cover reticle contacts includes a polymer material.

In an embodiment, each of the movable posts includes a polymer material.

In an embodiment, the one or more movable posts includes three or more movable posts.

In an embodiment, the one or more movable posts includes four movable posts.

In an embodiment, each of the one or more apertures is opposite one of the one or more cover reticle contacts when the cover and the baseplate are connected to one another.

In an embodiment, each of the one or more apertures are offset from the one or more cover reticle contacts when the cover and the baseplate are connected to one another.

In an embodiment, each of the one or more apertures is at a position corresponding to a corner of a reticle.

In an embodiment, the reticle pod further includes a seal disposed in each of the apertures.

In an embodiment, a method of providing contacts within a pod includes activating one or more latches located in a pod door by attaching the pod door to a pod dome using a cam, and driving, via the one or more latches or the cam, one or more movable posts to extend in a direction having a component perpendicular to a plane of the pod door. Each of the one or more movable posts extend through a baseplate into an inner portion of the pod when driven via the one or more latches or the cam.

In an embodiment, activating the one or more latches includes moving the one or more latches in one or more directions that are parallel to a plane of the pod door.

In an embodiment, driving, via the one or more latch, the movable post includes a camming surface on each of the one or more latches contacting one of the one or more movable posts.

In an embodiment, the method further includes placing a reticle on a baseplate of the pod, joining the baseplate of the pod to a cover of the pod, and placing the joined baseplate and cover into a space within the pod dome.

In an embodiment, the joined baseplate and cover are in contact with one or more projections from the pod dome when placed within the pod dome.

In an embodiment, at least three movable posts are driven via the one or more latches.

In an embodiment, the cover includes one or more cover reticle contacts, each of the cover reticle contacts opposite one of the movable posts.

In an embodiment, the cover includes one or more cover reticle contacts, each of the cover reticle contacts offset from the movable posts.

In an embodiment, the method further includes forming a seal between the baseplate and the one or more movable posts.

### Drawings

The disclosure may be more completely understood in consideration of the following description of various illustrative embodiments in connection with the accompanying drawings.
Figure 1 shows a reticle pod according to an embodiment including a partial sectional view.
Figure 1A shows the partial sectional view of Figure 1 expanded to provide further detail.
Figure 2 shows a plan view of a baseplate of a reticle pod according to an embodiment.
Figure 3 shows a sectional view of a reticle pod according to an embodiment.
Figure 4 shows a flowchart of a method of moving one or more reticle contacts according to an embodiment.

While the disclosure is amenable to various modifications and alternative forms, specifics thereof have been shown by way of example in the drawings and will be described in detail. It should be understood, however, that the intention is not to limit aspects of the disclosure to the particular illustrative embodiments described. On the contrary, the intention is to cover all modifications, equivalents, and alternatives falling within the spirit and scope of the disclosure.

### Detailed Description

The following detailed description should be read with reference to the drawings in which similar elements in different drawings are numbered the same. The detailed description and the drawings, which are not necessarily to scale, depict illustrative embodiments and are not intended to limit the scope of the invention. The illustrative embodiments depicted are intended only as exemplary. Selected features of any illustrative embodiment may be incorporated into an additional embodiment unless clearly stated to the contrary.

As used in this specification and the appended claims, the singular forms "a", "an", and "the" include plural referents unless the content clearly dictates otherwise. As used in this specification and the appended claims, the term "or" is generally employed in its sense including "and/or" unless the content clearly dictates otherwise.

The term "about" generally refers to a range of numbers that is considered equivalent to the recited value (e.g., having the same function or result). In many instances, the term "about" may include numbers that are rounded to the nearest significant figure.

This disclosure is directed to reticle pods and more particularly, to reticle pods including movable reticle retention features for retaining a reticle.

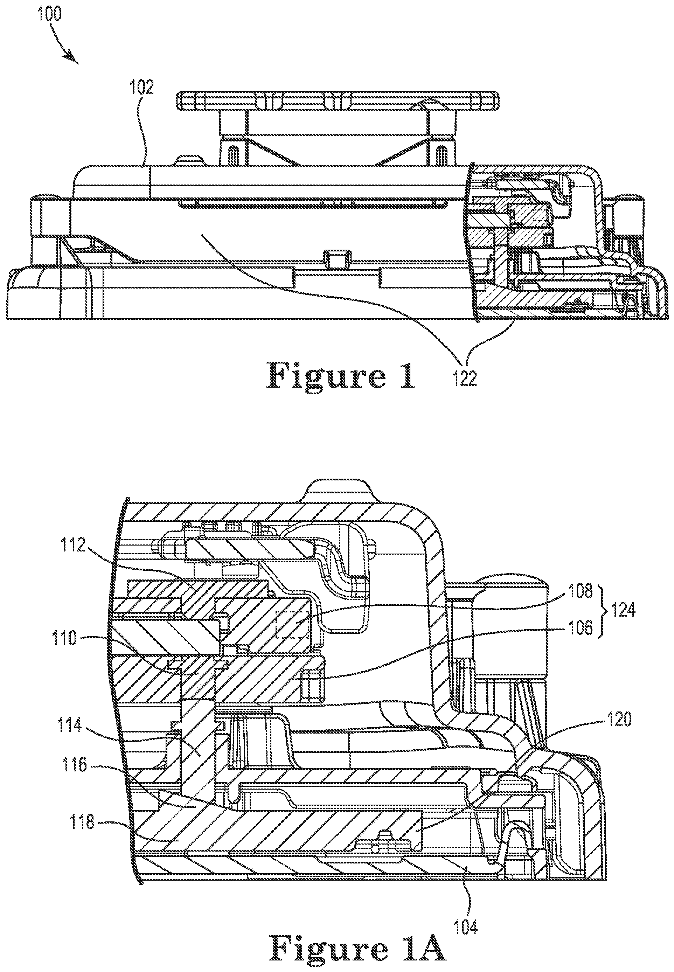

Figure 1 shows a reticle pod 100 according to an embodiment including a partial sectional view, and Figure 1A shows the partial sectional view of Figure 1 expanded to provide further detail.

Reticle pod 100 includes an outer portion 122 including pod dome 102 and pod door 104. Reticle pod 100 also includes an inner portion 124 including baseplate 106 and cover 108. Baseplate 106 includes movable reticle contacts 110. Cover 108 includes cover reticle contacts 112. Movable reticle contacts 110 are contacted by movable posts 114 when the inner and outer portions of reticle pod 100 are assembled and pod door 104 is joined to pod dome 102. Movable posts 114 are in contact with actuating mechanisms 116, which are driven by latch 118 of the pod door 104.

Pod dome 102 is part of the outer portion 122 of reticle pod 100. Pod dome 102 may include one or more features configured to contact cover 108 when the reticle pod 100 is assembled. Pod dome 102 includes an internal space. The internal space may include a first internal space sized to accommodate the inner portion 124 of reticle pod 100 and a second space at an end of pod dome 102 configured to accommodate pod door 104. The second space may be defined by a lip. The portion of pod dome 102 surrounding the second space may include one or more slots or other openings configured to receive an end of latch 118. Pod dome 102 may be made of a polymer material.

Pod door 104 is another part of the outer portion 122 of reticle pod 100. Pod door 104 is configured to be combined with pod dome 102 to form the outer portion 122 of the reticle pod 100. The pod door 104 may be sized such that it fits in a space of pod dome 102 such that it closes an end of pod dome 102. Pod door 104 includes latch 118 and actuating mechanisms 116. Pod door 104 further is connected to movable posts 114. Pod door 104 may be joined to pod dome 102 by one or more latches 118 when the latches 118 are in a deployed position. Pod door 104 may be removable from pod dome 102 when latches 118 are not in the deployed position.

When pod dome 102 and pod door 104 are joined together, the pod dome 102 and pod door 104 together define an internal space capable of accommodating the inner portion 124 of reticle pod 100 including baseplate 106 and cover 108. The pod dome 102 and the pod door 104 may include feature projecting into the internal space and configured to contact the baseplate 106 or cover 108 to hold the baseplate 106 or cover 108 in position when the reticle pod 100 is assembled.

Baseplate 106 is part of the inner portion 124 of reticle pod 100. When reticle pod 100 is assembled, baseplate 106 may be supported by pod door 104. The baseplate 106 typically forms the lower part of the inner portion 124 of reticle pod 100. The baseplate 106 may be configured such that a reticle may rest on baseplate 106. Baseplate 106 may be made of a metal or alloy. In an embodiment, baseplate 106 includes aluminum. In an embodiment, baseplate 106 can include reticle contacts, the reticle contacts having a height that is smaller than the height of the movable reticle contacts 110 when the movable reticle contacts 110 are extended.

Movable reticle contacts 110 are movably connected to the baseplate 106. The movable connection may be a connection via a resilient material. Non-limiting examples of the movable connection include a metal spring formed in baseplate 106, a spring separate from but connected to baseplate 106, a polymer such as rubber joining the movable reticle, or any other such movable connection. The movable reticle contacts 110 are configured to move in a direction having a component perpendicular to the plane of baseplate 106. In an embodiment the movable reticle contacts are configured to move in a direction perpendicular to the plane of baseplate 106. When baseplate 106 and cover 108 are joined, the movement of movable reticle contacts 110 is such that the movable reticle contacts move in a direction towards or away from cover 108. Movable reticle contacts 110 may include material compatible with a reticle material. Compatible materials include materials that provide minimal or no particle generation when in contact with the reticle material, and which cannot scratch or otherwise damage the reticle material. In an embodiment, the compatible material is a polymer material. In an embodiment, the entire movable reticle contact 110 is made of the compatible material. In an embodiment, the movable reticle contact includes a contact point including the compatible material. Non-limiting examples of the compatible material include polyether-ether-ketone (PEEK), polyaryl-ether-ketone (PAEK), polyamide-imide (PAI), polyether-imide (PEI), and conductive polymers.

Cover 108 is another part of the inner portion 124 of reticle pod 100. Cover 108 may form the upper part of the inner portion 124 of reticle pod 100 when the inner portion 124 is assembled from baseplate 106 and cover 108. Cover 108 is configured to be joined to baseplate 106, for example by having matching or mechanically compatible features. When cover 108 is joined to baseplate 106, cover 108 and baseplate 106 define an internal space configured to accommodate a reticle. Cover 108 may be made of a metal or alloy, for example, aluminum. Cover 108 may include one or more cover reticle contacts 112. In an embodiment, when the inner portion 124 of the reticle pod is placed within pod dome 102 and pod door 104, and pod door 104 is joined to pod dome 102, cover 108 is contacted by pod dome 102.

Cover reticle contacts 112 are contacts joined to cover 108 of the inner portion 124 of reticle pod 100. In an embodiment, cover reticle contacts 112 are fixed to the inside of the cover such that they face the baseplate 106 when the inner portion 124 of reticle pod 100 is assembled. In an embodiment, cover reticle contacts 112 are fixed in position. Non-limiting examples of the fixation of cover reticle contacts 112 include pressing, mechanical fastening, or being integral parts of the cover 108, for example being directly machined into cover 108. In an embodiment, cover reticle contacts 112 are movable, for example being retained by resilient members similar to the movable reticle contacts 110 joined to baseplate 106. Cover reticle contacts 112 may be positioned such that when the baseplate and the cover are assembled, the cover reticle contacts each oppose one of the movable reticle contacts 110. In an embodiment, cover reticle contacts 112 may be positioned such that they are offset from the movable reticle contacts 110; i.e. that the cover reticle contacts and the movable reticle contacts 110 are not opposite one another. When the movable reticle contacts 110 and the cover reticle contacts 112 are offset from one another and the baseplate and cover are assembled together, the cover reticle contacts 112 are not above the movable reticle contacts 110. In an embodiment, the reticle pod 100 includes at least three cover reticle contacts 112. In an embodiment, the reticle pod 100 includes four cover reticle contacts 112. In an embodiment, the reticle pod 100 includes eight cover reticle contacts 112. Cover reticle contacts 112 include a material compatible with the reticle material. Compatible materials include materials that provide minimal or no particle generation when in contact with the reticle material, and which cannot scratch or otherwise damage the reticle material. In an embodiment, the compatible material is a polymer material. Cover reticle contacts 112 may include the compatible material at least at a contact point configured to contact a reticle when reticle pod 100 is assembled. In an embodiment, the cover reticle contacts 112 are entirely made of a polymer material suitable for contacting the reticle. Non-limiting examples of the compatible material include polyether-ether-ketone (PEEK), polyaryl-ether-ketone (PAEK), polyamide-imide (PAI), polyether-imide (PEI), and conductive polymers.

Movable posts 114 are one or more posts located on the pod door that are configured to contact the movable reticle contacts 110 when reticle pod 100 is assembled and pod door 104 is fixed to pod dome 102 via latch 118. Movable posts 114 protrude from a surface of pod door 104 facing baseplate 106 at least when pod door 104 is fixed to pod dome 102 via latch 118. Movable posts 114 may be flush with pod door 104, recessed into pod door 104, or protruding a smaller distance from pod door 104 when pod door 104 is not fixed to pod dome 102. Movable posts 114 are movable in a direction having a component in a vertical direction with respect to the surface of pod door 104 facing baseplate 106 when reticle pod 100 is assembled. In an embodiment, movable posts 114 are movable in the vertical direction with respect to the surface of pod door 104 facing baseplate 106 when reticle pod 100 is assembled. The number of movable posts 114 may be the same as the number of movable reticle contacts 110.

In an alternative embodiment, movable posts 114 may have a length such that they extend through the baseplate when the reticle pod 100 is assembled and latch 118 closed. In this embodiment, apertures are formed in the baseplate 106, for example at the locations of the movable reticle contacts 110. The apertures may be the openings where movable reticle contacts 110 are disposed in baseplate 106. In this embodiment, the movable posts may include material compatible with a reticle material. Compatible materials include materials that provide minimal or no particle generation when in contact with the reticle material, and which cannot scratch or otherwise damage the reticle material. In an embodiment, the compatible material is a polymer material. In an embodiment, the movable post 114 is made of the compatible material. In an embodiment, the movable post 114 includes a contact point including the compatible material. Non-limiting examples of the compatible material include polyether-ether-ketone (PEEK), polyaryl-ether-ketone (PAEK), polyamide-imide (PAI), polyether-imide (PEI), and conductive polymers. In this embodiment, the apertures in baseplate 106 may include seals configured to form a seal around the movable post 114 when the movable post 114 extends through the aperture. The seals may be, for example, O-rings.

Actuating mechanism 116 includes one or more components located within the pod door 104 and configured to drive the movable posts based on movement of latch 118. The actuating mechanism 116 is any one or more mechanisms to translate movement of the latch 118 to movement of the movable posts 114. In an embodiment, actuating mechanism 116 includes one or more sliding surfaces formed on latch 118. In an embodiment, actuating mechanism 116 includes one or more rocker arms. In an embodiment, actuating mechanism 116 includes one or more camming surfaces configured to contact the latch 118 such that movement of the latch 118 causes actuating mechanism to slide, rock, or cam with respect to the movable posts 114.

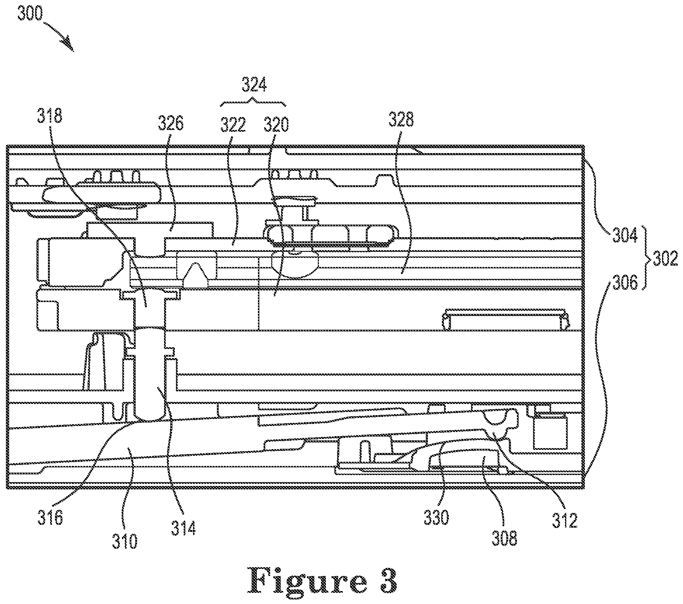

Latch 118 is a latch securing the pod door 104 to pod dome 102. Latch 118 may include a latch pin 120 configured to, in a deployed position, engage pod dome 104 to secure pod door 102. In an embodiment, the latch 118 further includes a rotational actuator (not shown) configured to extend and retract the latch pin 120. In an embodiment, the rotational actuator includes a cam, for example, the latch cam 308 shown in Figure 3 and discussed below. In an embodiment, operation of the rotational actuator drives the one or more movable posts 114. In an embodiment, operation of the rotational actuator can cause lifting of at least a portion of each of the latch pins. In a retracted position, latch 118 may be entirely within pod door 104. Latch 118 may include one or more sliding surfaces that function as actuating mechanism 116. Latch 118 may include one or more engagement features configured to interact with actuating mechanism 116, such as one or more surfaces configured to contact a rocker arm, one or more cams or camming surfaces configured to contact camming surfaces of actuating mechanism 118, or other suitable features for contacting actuating mechanism 116. The engagement features of latch 118 may contact the actuating mechanism 116 when the latch 118 is in the deployed position. In an embodiment, pod door 104 includes a knob, switch, toggle, or other such suitable control to move the latch between deployed and retracted states. In an embodiment, latch 118 is configured to be deployed when pod door 104 is pressed against pod dome 102.

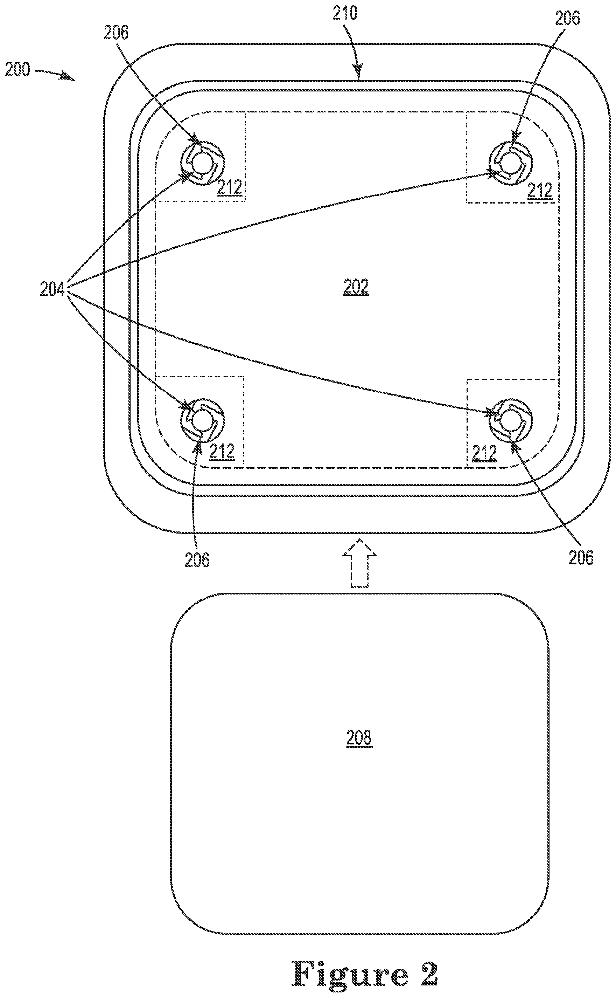

Figure 2 shows a plan view of a baseplate 200 of a reticle pod according to an embodiment. Baseplate 200 includes a space 202 for a reticle 208 and movable reticle contacts 204. Each of movable reticle contacts 204 is retained via a flexible member 206. The reticle contacts 204 are located at positions that would correspond to corners of the reticle 208 when that reticle is placed within the space for the reticle 202.

Space for the reticle 202 is a portion of the baseplate where a reticle may be placed. Reticle 208 is illustrated to show the fit of the reticle 208 within space for the reticle 202. In an embodiment, space for the reticle 202 may be defined by side walls 210. In an embodiment, the space for the reticle 202 may be a portion of the surface of the baseplate that is surrounded by the cover when the cover is attached to the baseplate 200. The shape of space for the reticle 202 may be configured to follow the shape of the reticle 208, for example being square for a square reticle or circular for a circular reticle. The space for the reticle 202 may be sized such that it is slightly larger than the reticle 208 to be placed within.

Movable reticle contacts 204 are distributed along baseplate 200, within the space for the reticle 202. In an embodiment, the movable reticle contacts are located in the areas 212 of the space for the reticle 202 corresponding to corners of the reticle 208. When the reticle 208 is placed within the space for the reticle 202, it may rest on the movable reticle contacts 204. Movable reticle contacts 204 may be made of a suitable material for contacting and retaining the reticle 208 in position, such as a polymer material. The material of movable reticle contacts 204 may be compatible with the material of reticle 208, such that contact between them does not generate particles or cause any scratches or damage to the reticle 208. In an embodiment, movable reticle contacts include a polymer material at least at the point where they are configured to contact reticle 208. Reticle 208 may be placed on movable reticle contacts 204 when assembling a reticle pod including baseplate 200. Movable reticle contacts 204 may have a standard position and a retention position, where the movable reticle contacts 204 are configured to clamp the reticle 208 to another feature such as reticle contacts on a cover of the reticle pod including baseplate 200. The standard position may be taken by the movable reticle contacts 204 when the pod door is not secured to the pod dome for the reticle pod including baseplate 200. In the standard position, the reticle 208 may rest on the movable reticle contacts 204 when the reticle 208 is placed into the space for the reticle 202. In the standard position, when the pod door is not secured to the pod dome, there may be a gap between an upper surface of the reticle 208 and all features of the cover including any reticle contacts on the cover.

Flexible member 206 retains movable reticle contact 204 to baseplate 200. Flexible member 206 may be, for example, a metal spring, a resilient polymer material, or another suitable connection joining reticle contacts 204 to baseplate 200 such that the movable reticle contacts 204 are movable with respect to the baseplate 200. As shown in Figure 2, the flexible member 206 may be a metal spring formed integrally with the baseplate 200, for example a metal spring defined by removal of material and providing a connection point for the movable reticle contact 204 such as a groove or hole into which a portion of the movable reticle contact may be inserted. Flexible member 206 may include a resilient polymer, such as rubber. Flexible member 206 may include resilient polymer formed integrally with the movable reticle contact 204, such as posts, tabs, or a ring of resilient polymer extending from the movable reticle contact 204 to one or more securing points on the baseplate 200. Flexible member 200 may be elastic such that it moves or retains movable reticle contact in the standard position in the absence of other forces, and allows movement of the movable reticle contact 204 into the retention position when force is applied to the movable reticle contact 204 or the flexible member 206.

One or both of each of the movable reticle contacts 204 or flexible member 206 include a surface presented on the side of the baseplate 200 opposite the side visible in Figure 2. This surface of one or both of each of the movable reticle contacts 204 or flexible member 206 may be contacted by a movable post included on a pod door of a reticle pod including baseplate 200. Contact with the movable post may cause the movable reticle contacts 204 to be moved in a direction having a component perpendicular to the plane of baseplate 200, such that the movable reticle contacts 204 are moved towards a cover that is placed on the baseplate. The movement of the movable reticle contacts 204 may cause a reticle 208 to be clamped between and reticle contacts on the cover. This clamping of reticle 208 may secure the position of reticle 208 to restrict or prevent movement of the reticle when the reticle pod including baseplate 200 is fully assembled and the pod dome is secured to the pod door. The securing of the pod dome to the pod door may be via one or more latches in the pod door. These one or more latches may actuate the movable posts and drive them to contact one or both of each of the movable reticle contacts 204 or flexible member 206. The one or more latches may thus cause movement of the movable reticle contacts 204 between the standard position and the retention position.

Figure 3 shows a sectional view of a reticle pod according to an embodiment. Reticle pod 300 includes an outer portion 302 including a pod dome 304 and a pod door 306. Pod door 306 includes a latch cam 308 and a latch arm 310. Latch arm 310 includes a contact point 312 in contact with latch cam 308. Latch arm 310 also contacts movable post 314 at end 316 of the movable post 314. Movable post 314 contacts movable reticle contact 318. Movable reticle contact 318 extends through baseplate 320. Baseplate 320 and cover 322 form the inner portion 324 of the reticle pod 300. Cover 322 includes cover reticle contacts 326. When reticle pod 300 is assembled, cover reticle contacts 326 and movable reticle contacts 318 are configured to clamp a reticle 328 within the inner portion 324 of the reticle pod 300.

Pod dome 304 is part of outer portion 302 of reticle pod 300. Pod dome 304 in part defines an internal space capable of accommodating the inner portion 324 of the reticle pod 300. Pod door 306 is configured to be joined with pod dome 304 to form the outer portion 302 and fully define the internal space capable of accommodating the inner portion 324. Pod door 306 can be joined to pod dome 304 by a latch including latch cam 308 and two or more latch arms 310.

Latch cam 308 is a cam configured to actuate latch arms 310 when the latch cam 308 is rotated. Latch cam 308 can be joined to a handle allowing a user to drive rotation of the latch cam 308. The latch cam 308 can include one or more camming surfaces 330 configured to engage contact points 312 formed on latch arms 310 to move latch arms 310. In an embodiment, the camming surfaces 330 drive the ends of latch arms 310 having contact points 312 upwards as they drive the latch arms 310 into extended positions.

Latch arm 310 is an arm configured to engage with pod dome 304 to secure pod door 306 to the pod dome 304 when in an extended position. Latch arm 310 can also be in a retracted position where it does not engage with pod dome 304. Latch arm 310 can be driven to the retracted and extended positions by the operation of the latch cam 308. Contact point 312 is a point on latch arm 310 that engages with latch cam 308. Contact point 312 can be formed integrally with latch arm 310, such as a projection from latch arm 310. Engagement of contact point 312 with latch cam 308 can drive latch arm 310 to move between extended and retracted positions. Engagement of contact point 312 with latch cam 308 can further cause tilting of the latch arm 310, for example lifting an end of the latch arm 310 that includes contact point 312 when the latch cam 308 drives the latch arm 310 to the extended position, as visible in Figure 3.

Movable posts 314 are one or more posts located on the pod door that are configured to contact the movable reticle contacts 318 when reticle pod 300 is assembled and pod door 306 is fixed to pod dome 304 via the latch including latch cam 308 and latch arm 310. Movable posts 314 protrude from a surface of pod door 306 facing baseplate 320 at least when pod door 306 is fixed to pod dome 304 via the latch including latch cam 308 and latch arm 310. Movable posts 314 may be flush with pod door 306, recessed into pod door 306, or protruding a smaller distance from pod door 306 when pod door 306 is not fixed to pod dome 304. Movable posts 314 are movable in a direction having a component in a vertical direction with respect to the surface of pod door 306 facing baseplate 320 when reticle pod 300 is assembled. In an embodiment, movable posts 314 are movable in the vertical direction with respect to the surface of pod door 306 facing baseplate 320 when reticle pod 300 is assembled. The number of movable posts 314 may be the same as the number of movable reticle contacts 318. In an embodiment, the vertical direction is perpendicular to the plane of pod door 306.

Movable post 314 includes an end 316 opposite the movable reticle contact 318. The end 316 can contact the latch arm 310 such that at least a component of movement of the latch arm 310 is transferred to movable post 314. In an embodiment, the component of movement of the latch arm 310 that is transferred to movable post 314 is the component that is perpendicular to the plane of pod door 306. The contact of the can drive movable post 314 to change positions based on the position of the latch arm 310, for example driving the movable post towards the baseplate 320 when the latch cam 308 is rotated to extend the latch arm 310 and in turn raises the end of the latch arm including the contact point 312.

Movable reticle contact 318 is movably connected to the baseplate 320. The movable connection may be a connection via a resilient material. Non-limiting examples of the movable connection include a metal spring formed in baseplate 320, a spring separate from but connected to baseplate 320, a polymer such as rubber joining the movable reticle, or any other such movable connection. The movable reticle contacts 318 are configured to move in a direction having a component perpendicular to the plane of baseplate 320. In an embodiment the movable reticle contacts are configured to move in a direction perpendicular to the plane of baseplate 320. When baseplate 320 and cover 322 are joined, the movement of movable reticle contacts 318 is such that the movable reticle contacts move in a direction towards or away from cover 322. Movable reticle contacts 318 may include material compatible with a reticle material. Compatible materials include materials that provide minimal or no particle generation when in contact with the reticle material, and which cannot scratch or otherwise damage the reticle material. In an embodiment, the compatible material is a polymer material. In an embodiment, the entire movable reticle contact 318 is made of the compatible material. In an embodiment, the movable reticle contact includes a contact point including the compatible material. Non-limiting examples of the compatible material include polyether-ether-ketone (PEEK), polyaryl-ether-ketone (PAEK), polyamide-imide (PAI), polyether-imide (PEI), and conductive polymers.

Baseplate 320 is part of the inner portion 324 of reticle pod 300. When reticle pod 300 is assembled, baseplate 320 may be supported by pod door 306. The baseplate 320 typically forms the lower part of the inner portion 324 of reticle pod 300. The baseplate 320 may be configured such that a reticle 328 may rest on baseplate 320. Baseplate 320 may be made of a metal or alloy. In an embodiment, baseplate 320 includes aluminum. In an embodiment, baseplate 320 can include reticle contacts, the reticle contacts having a height that is smaller than the height of the movable reticle contacts 318 when the movable reticle contacts 318 are extended.

Cover 322 is another part of the inner portion 324 of reticle pod 300. Cover 322 may form the upper part of the inner portion 324 of reticle pod 300 when the inner portion 324 is assembled from baseplate 320 and cover 322. Cover 322 is configured to be joined to baseplate 320, for example by having matching or mechanically compatible features. When cover 322 is joined to baseplate 320, cover 322 and baseplate 320 define an internal space configured to accommodate a reticle 328. Cover 322 may be made of a metal or alloy, for example, aluminum. Cover 322 may include one or more cover reticle contacts 326. In an embodiment, when the inner portion 324 of the reticle pod 300 is placed within pod dome 304 and pod door 306, and pod door 306 is joined to pod dome 304, cover 322 is contacted by pod dome 304.

Cover reticle contacts 326 are contacts joined to cover 322 of the inner portion 324 of reticle pod 300. In an embodiment, cover reticle contacts 326 are fixed to the inside of the cover such that they face the baseplate 320 when the inner portion 324 of reticle pod 300 is assembled. In an embodiment, cover reticle contacts 326 are fixed in position. Non-limiting examples of the fixation of cover reticle contacts 326 include pressing, mechanical fastening, or being integral parts of the cover 322, for example being directly machined into cover 322. In an embodiment, cover reticle contacts 326 are movable, for example being retained by resilient members similar to the movable reticle contacts 316 joined to baseplate 320. Cover reticle contacts 326 may be positioned such that when the baseplate and the cover are assembled, the cover reticle contacts each oppose one of the movable reticle contacts 318. In an embodiment, cover reticle contacts 326 may be positioned such that they are offset from the movable reticle contacts 318; i.e. that the cover reticle contacts 326 and the movable reticle contacts 318 are not opposite one another. When the movable reticle contacts 318 and the cover reticle contacts 326 are offset from one another and the baseplate and cover are assembled together, the cover reticle contacts 326 are not above the movable reticle contacts 318. In an embodiment, the reticle pod 300 includes at least three cover reticle contacts 326. In an embodiment, the reticle pod 300 includes four cover reticle contacts 326. In an embodiment, the reticle pod 300 includes eight cover reticle contacts 326. Cover reticle contacts 326 include a material compatible with the reticle material. Compatible materials include materials that provide minimal or no particle generation when in contact with the reticle material, and which cannot scratch or otherwise damage the reticle material. In an embodiment, the compatible material is a polymer material. Cover reticle contacts 326 may include the compatible material at least at a contact point configured to contact a reticle when reticle pod 300 is assembled. In an embodiment, the cover reticle contacts 326 are entirely made of a polymer material suitable for contacting the reticle. Non-limiting examples of the compatible material include polyether-ether-ketone (PEEK), polyaryl-ether-ketone (PAEK), polyamide-imide (PAI), polyether-imide (PEI), and conductive polymers.

Baseplate 320 and cover 322 join together to form inner portion 324 of the reticle pod 300. Inner portion 324 is located entirely inside the space within pod dome 304 and pod door 306.

Reticle 328 is a reticle such as, for example, a photolithography mask. Reticle 328 can be located within an internal space of the inner portion 324 of the reticle pod 300. When reticle 328 is located within the inner portion 324, the inner portion is located within the outer portion 302, and pod dome 304 and pod door 306 are secured to one another by the latch including latch cam 308 and latch arm 310.

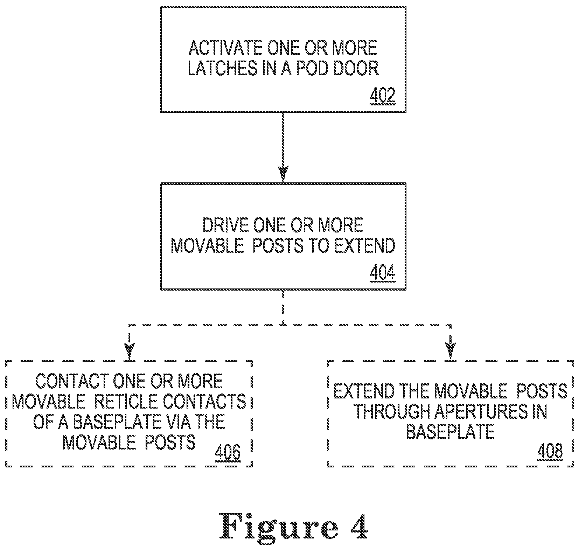

Figure 4 shows a flowchart of a method of moving one or more reticle contacts according to an embodiment. The method 400 includes activating one or more latches located in a pod door, attaching the pod door to a pod dome 402. The method 400 further includes driving one or more movable posts to extend in a direction having a component perpendicular to a plane of the pod door 404. The method 400 also includes contacting one or more movable reticle contacts of a baseplate via the one or more movable posts 406.

One or more latches located in a pod door are activated attaching the pod door to a pod dome at 402. The pod door and the pod dome may form an outer portion of a reticle pod. The pod door and the pod dome may define an internal space. The pod door and the pod dome may be, for example, pod door 102 and pod door 104 described above and shown in Figure 1. Activating the latch at 402 causes the latch to move into a deployed position where the latch secures the pod door to the pod dome. An inner portion of the reticle pod including a cover and a baseplate, such as cover 106 and baseplate 108 or baseplate 200 may be included within the internal space. The one or more latches may be activated 402 automatically by attaching the pod door to the pod dome. The one or more latches may be activated 402 by mechanically operating a knob, slider, or other feature, either manually or via another device. Activation of the one or more latches at 402 causes the latches to move. Movement of the latches caused by activation of 402 may cause contact between the latches and one or more actuator mechanism or direct contact with one or more movable posts.

One or more movable posts are driven to extend in a direction having a component perpendicular to a plane of the pod door at 404. In an embodiment, the movable posts are driven as a result of the activation of the one or more latches at 402. The movable posts may be connected to the pod door. The movable posts may be positioned so that each corresponds to a reticle contact included in a baseplate that is included in the reticle pod, the baseplate being part of the inner portion of the reticle pod in an internal space defined by the pod door and the pod dome. The movable posts may be driven via their contact with the one or more latches or with one or more actuators. Contact between the movable post and the latch may be at sliding surfaces respectively included in each of the latch and the movable post. The one or more actuators may include, for example, a rocker arm, a camming surface, or a sliding surface. In an embodiment, one or more of the movable posts are driven by contact between the movable post and a sliding surface included on the latch. The sliding surface may have a wedge shape. The wedge shape of the sliding surface may drive the movement of the movable post in the direction having a component perpendicular to a plane of the pod door. The direction having a component perpendicular to a plane of the pod door may be a direction towards the baseplate of an inner part of the reticle pod when the reticle pod is assembled. In an embodiment, a rocker arm is actuated by the latch, and the rocker arm drives the one or more movable posts. In an embodiment, a camming surface of each actuator contacts the latch, with movement of the latch causing camming that results in movement of the actuator that in turn drives the one or more movable posts are driven to extend in a direction having a component perpendicular to a plane of the pod door.

In an embodiment, one or more movable reticle contacts of a baseplate are contacted via the one or more movable posts 406. As a result of the contact at 406, the one or more movable reticle contacts in the baseplate may be moved towards a cover that is part of the inner portion of the reticle pod. When the one or more movable contacts are contacted by the movable posts at 406, the movable reticle contacts may be moved towards a cover joined to the baseplate. Movement of the movable reticle contacts may be to a position such that a reticle located between the cover and the baseplate would be clamped between the movable reticle contact and reticle contacts on a cover joined to the baseplate. This clamping may be such that it secures the reticle while the cover and baseplate are joined, while combined reticle cover and baseplate are located within the pod door and pod dome, and while the pod door is latched to the pod dome. The reticle contacts may be retained in this position by the movable posts while the pod door remains secured to the pod dome via the latch actuated at 402. In an embodiment, movement of the one or more movable reticle contacts may be movement of each of the movable reticle contacts towards a reticle contact on the cover, opposite each of the one or more movable reticle contacts. In an embodiment, movement of the one or more movable reticle contacts is towards the cover, and reticle contacts included on the cover are offset from the movable reticle contacts on the baseplate, such that the respective reticle contacts on the cover and the baseplate are not opposite one another.

In an embodiment, step 406 may be replaced by extending the movable posts through apertures in the baseplate 408. In this embodiment, the baseplate includes an aperture for each of the one or more movable posts. The movable posts are driven to pass through the apertures when the one or more movable posts are driven to extend in a direction having a component perpendicular to a plane of the pod door at 404. In an embodiment, the movable posts may be pushed through a seal configured to form a seal at the aperture when the movable post is extending through the aperture. The seal may be, as a non-limiting example, an O-ring. In an embodiment, the movable posts may include a contact surface made of a compatible material.

### Aspects:

It is understood that any of aspects 1-14 can be combined with any of aspects 15-22. It is understood that any of aspects 23-34 may be combined with any of aspects 35-43.

The examples disclosed in this application are to be considered in all respects as illustrative and not limitative. The scope of the invention is indicated by the appended claims rather than by the foregoing description; and all changes which come within the meaning and range of equivalency of the claims are intended to be embraced therein.

## Claims

1. A reticle pod (100/300), comprising: an inner portion (124/324) including a cover (108/322) and a baseplate (106/320), wherein the cover includes one or more cover reticle contacts (112/326) joined to the cover and the baseplate includes one or more movable reticle contacts (110/204/318), the one or more movable reticle contacts each configured to be movable in a direction having a component perpendicular to the plane of the baseplate; and an outer portion (122/302) including a pod dome (102/304/402) and a pod door (104/306/404), wherein the pod door includes one or more movable posts (114/314) and one or more latches (118) configured to drive the one or more movable posts, wherein when the inner portion is located within the outer portion and the pod door is fixed to the pod dome, the one or more movable posts contact the one or more movable reticle contacts such that the one or more movable reticle contacts are moved towards the cover.

2. The reticle pod of claim 1, wherein each of the one or more movable reticle contacts are retained in the baseplate via a flexible member.

3. The reticle pod of claim 2, wherein when the flexible member is at rest, the movable reticle contact is at a distance from at least one of the one or more cover reticle contacts that is greater than a thickness of a reticle to be stored in the reticle pod.

4. The reticle pod of any preceding claim, wherein the one or more movable reticle contacts are each configured to be movable in a direction perpendicular to the plane of the baseplate.

5. The reticle pod of any preceding claim, wherein the pod dome includes one or more projections that contact the cover when the inner portion is located within the outer portion and the pod door is fixed to the pod dome.

6. The reticle pod of any preceding claim, wherein each of the cover reticle contacts and each of the movable reticle contacts includes a polymer material.

7. The reticle pod of any preceding claim, wherein the one or more movable reticle contacts includes four movable reticle contacts.

8. The reticle pod of any preceding claim, wherein each of the one or more movable reticle contacts is opposite one of the one or more cover reticle contacts when the cover engages the baseplate.

9. The reticle pod of any preceding claim, wherein each of the one or more movable reticle contacts are offset from the one or more cover reticle contacts when the cover engages the baseplate.

10. A method of moving contacts within a pod, comprising: activating one or more latches (118) located in a pod door (104/306/404) by attaching the pod door to a pod dome (102/304/402); and driving, via the one or more latches, one or more movable posts (114/314) to extend in a direction having a component perpendicular to a plane of the pod door, wherein each of the one or more movable posts contacts a movable reticle contact (110/204/318) of a baseplate (106/320) located within the pod door and the pod dome, such that the movable reticle contact moves in a direction towards a cover (108/322) located within the pod door and the pod dome.

11. The method of claim 10, further comprising placing a reticle on a baseplate of the pod, joining the baseplate of the pod to a cover of the pod, and placing the joined baseplate and cover into a space within the pod dome.

12. The method of claim 11, wherein the joined baseplate and cover are in contact with one or more projections from the pod dome when placed within the pod dome.

13. The method of any of claims 10-12, wherein at least three movable posts are driven via the one or more latches.

14. A reticle pod (100/300), comprising: an inner portion (124/134) including a cover (108/322) and a baseplate (106/320), wherein the cover includes one or more cover reticle contacts (112/326) joined to the cover and the baseplate includes one or more apertures; and an outer portion (122/302) including a pod dome (102/304/402) and a pod door (104/306/404), wherein the pod door includes one or more movable posts (114/314) and one or more latches (118) configured to drive the one or more movable posts, wherein when the inner portion is located within the outer portion and the pod door is fixed to the pod dome, the one or more movable posts extend through the one or more apertures into the inner portion.

15. A method of providing contacts within a pod, comprising: activating one or more latches (118) located in a pod door (104/306/404) by attaching the pod door to a pod dome (102/304/402) using a cam (308); and driving, via the one or more latches or the cam, one or more movable posts (114/314) to extend in a direction having a component perpendicular to a plane of the pod door, wherein each of the one or more movable posts extend through a baseplate (106/320) into an inner portion (124/324) of the pod when driven via the one or more latches or the cam.

## Patentansprüche

1. Maskenhalter (100/300), umfassend: einen inneren Abschnitt (124/324), der eine Abdeckung (108/322) und eine Grundplatte (106/320) beinhaltet, wobei die Abdeckung einen oder mehrere Abdeckungsmaskenkontakte (112/326) beinhaltet, die mit der Abdeckung verbunden sind, und die Grundplatte einen oder mehrere bewegbare Maskenkontakte (110/204/318) beinhaltet, wobei der eine oder die mehreren bewegbaren Maskenkontakte jeweils konfiguriert sind, um in einer Richtung bewegbar zu sein, die eine Komponente senkrecht zu der Ebene der Grundplatte aufweist; und einen äußeren Abschnitt (122/302), der eine Halterkuppel (102/304/402) und eine Haltertür (104/306/404) beinhaltet, wobei die Haltertür einen oder mehrere bewegbare Pfosten (114/314) und eine oder mehrere Verriegelungen (118) beinhaltet, die konfiguriert sind, um den einen oder die mehreren bewegbaren Pfosten anzutreiben, wobei, wenn sich der innere Abschnitt innerhalb des äußeren Abschnittes befindet und die Haltertür an der Halterkuppel befestigt ist, der eine oder die mehreren bewegbaren Pfosten den einen oder die mehreren bewegbaren Maskenkontakte kontaktieren, sodass der eine oder die mehreren bewegbaren Maskenkontakte zu der Abdeckung bewegt werden.

2. Maskenhalter nach Anspruch 1, wobei jeder von dem einen oder den mehreren bewegbaren Maskenkontakten in der Grundplatte über ein flexibles Element gehalten wird.

3. Maskenhalter nach Anspruch 2, wobei, wenn das flexible Element in Ruhe ist, der bewegbare Maskenkontakt in einem Abstand von zumindest einem von dem einen oder den mehreren Abdeckungsmaskenkontakten ist, der größer als eine Dicke einer Maske ist, die in dem Maskenhalter zu lagern ist.

4. Maskenhalter nach einem vorhergehenden Anspruch, wobei der eine oder die mehreren bewegbaren Maskenkontakte jeweils konfiguriert sind, um in einer Richtung senkrecht zu der Ebene der Grundplatte bewegbar zu sein.

5. Maskenhalter nach einem vorhergehenden Anspruch, wobei die Halterkuppel einen oder mehrere Vorsprünge beinhaltet, welche die Abdeckung kontaktieren, wenn sich der innere Abschnitt innerhalb des äußeren Abschnittes befindet und die Haltertür an der Halterkuppel befestigt ist.

6. Maskenhalter nach einem vorhergehenden Anspruch, wobei jeder der Abdeckungsmaskenkontakte und jeder der bewegbaren Maskenkontakte ein Polymermaterial beinhaltet.

7. Maskenhalter nach einem vorhergehenden Anspruch, wobei der eine oder die mehreren bewegbaren Maskenkontakte vier bewegbare Maskenkontakte beinhalten.

8. Maskenhalter nach einem vorhergehenden Anspruch, wobei jeder von dem einen oder den mehreren bewegbaren Maskenkontakten gegenüber einem von dem einen oder den mehreren Abdeckungsmaskenkontakten ist, wenn die Abdeckung die Grundplatte in Eingriff nimmt.

9. Maskenhalter nach einem vorhergehenden Anspruch, wobei jeder von dem einen oder den mehreren bewegbaren Maskenkontakten von dem einen oder den mehreren Abdeckungsmaskenkontakten versetzt ist, wenn die Abdeckung die Grundplatte in Eingriff nimmt.

10. Verfahren zum Bewegen von Kontakten innerhalb eines Halters, umfassend: Aktivieren von einer oder mehreren Verriegelungen (118), die sich in einer Haltertür (104/306/404) befinden, durch Anbringen der Haltertür an einer Halterkuppel (102/304/402); und Antreiben, über die eine oder mehreren Verriegelungen, von einem oder mehreren bewegbaren Pfosten (114/314), um sich in einer Richtung zu erstrecken, die eine Komponente senkrecht zu einer Ebene der Haltertür aufweist, wobei jeder von dem einen oder den mehreren bewegbaren Pfosten einen bewegbaren Maskenkontakt (110/204/318) einer Grundplatte (106/320) kontaktiert, die sich innerhalb der Haltertür und der Halterkuppel befindet, sodass sich der bewegbare Maskenkontakt in einer Richtung zu einer Abdeckung (108/322) bewegt, die sich innerhalb der Haltertür und der Halterkuppel befindet.

11. Verfahren nach Anspruch 10, ferner umfassend Platzieren einer Maske auf einer Grundplatte des Halters, Verbinden der Grundplatte des Halters mit einer Abdeckung des Halters und Platzieren der verbundenen Grundplatte und Abdeckung in einem Raum innerhalb der Halterkuppel.

12. Verfahren nach Anspruch 11, wobei die verbundene Grundplatte und Abdeckung in Kontakt mit einem oder mehreren Vorsprüngen von der Halterkuppel sind, wenn sie innerhalb der Halterkuppel platziert sind.

13. Verfahren nach einem der Ansprüche 10-12, wobei zumindest drei bewegbare Pfosten über die eine oder mehreren Verriegelungen angetrieben werden.

14. Maskenhalter (100/300), umfassend: einen inneren Abschnitt (124/134), der eine Abdeckung (108/322) und eine Grundplatte (106/320) beinhaltet, wobei die Abdeckung einen oder mehrere Abdeckungsmaskenkontakte (112/326) beinhaltet, die mit der Abdeckung verbunden sind, und die Grundplatte eine oder mehrere Öffnungen beinhaltet; und einen äußeren Abschnitt (122/302), der eine Halterkuppel (102/304/402) und eine Haltertür (104/306/404) beinhaltet, wobei die Haltertür einen oder mehrere bewegbare Pfosten (114/314) und eine oder mehrere Verriegelungen (118) beinhaltet, die konfiguriert sind, um den einen oder die mehreren bewegbaren Pfosten anzutreiben, wobei, wenn sich der innere Abschnitt innerhalb des äußeren Abschnittes befindet und die Haltertür an der Halterkuppel befestigt ist, sich der eine oder die mehreren bewegbaren Pfosten durch die eine oder mehreren Öffnungen in den inneren Abschnitt erstrecken.

15. Verfahren zum Bereitstellen von Kontakten innerhalb eines Halters, umfassend: Aktivieren von einer oder mehreren Verriegelungen (118), die sich in einer Haltertür (104/306/404) befinden, durch Anbringen der Haltertür an einer Halterkuppel (102/304/402) unter Verwendung einer Nocke (308); und Antreiben, über die eine oder mehreren Verriegelungen oder die Nocke, von einem oder mehreren bewegbaren Pfosten (114/314), um sich in einer Richtung zu erstrecken, die eine Komponente senkrecht zu einer Ebene der Haltertür aufweist, wobei sich jeder von dem einen oder den mehreren bewegbaren Pfosten durch eine Grundplatte (106/320) in einen inneren Abschnitt (124/324) des Halters erstreckt, wenn er über die eine oder mehreren Verriegelungen oder die Nocke angetrieben wird.

## Revendications

1. Nacelle de réticule (100/300), comprenant : une partie interne (124/324) comprenant un couvercle (108/322) et une plaque de base (106/320), ledit couvercle comprenant un ou plusieurs contacts de réticule de couvercle (112/326) joints au couvercle et ladite plaque de base comprenant un ou plusieurs contacts de réticule mobiles (110/204/318), le ou les contacts de réticule mobiles étant chacun conçus pour être mobiles dans une direction comportant une composante perpendiculaire au plan de la plaque de base ; et une partie externe (122/302) comprenant un dôme de nacelle (102/304/402) et une porte (104/306/404) de nacelle, la porte de nacelle comprenant un ou plusieurs montants mobiles (114/314) et un ou plusieurs verrous (118) conçus pour entraîner le ou les montants mobiles, lorsque la partie interne est située à l'intérieur de la partie externe et que la porte de nacelle est fixée au dôme de nacelle, ledit ou lesdits montants mobiles entrant en contact avec le ou les montants de réticule mobiles de sorte que le ou les contacts de réticule mobiles sont déplacés vers le couvercle.

2. Nacelle de réticule de la revendication 1, chacun dudit ou desdits contacts de réticule mobiles étant retenu dans la plaque de base par l'intermédiaire d'un élément souple.

3. Nacelle de réticule de la revendication 2, lorsque l'élément flexible est au repos, ledit contact de réticule mobile étant à une distance d'au moins l'un du ou des contacts de réticule de couvercle qui est supérieure à une épaisseur d'un réticule à stocker dans la nacelle de réticule.

4. Nacelle de réticule d'une quelconque revendication précédente, ledit ou lesdits contacts de réticule mobiles étant chacun conçus pour être mobiles dans une direction perpendiculaire au plan de la plaque de base.

5. Nacelle de réticule d'une quelconque revendication précédente, ledit dôme de nacelle comprenant une ou plusieurs saillies qui entrent en contact avec le couvercle lorsque la partie interne est située à l'intérieur de la partie externe et que la porte de nacelle est fixée au dôme de nacelle.

6. Nacelle de réticule d'une quelconque revendication précédente, chacun des contacts de réticule de couvercle et chacun des contacts de réticule mobiles comprenant un matériau polymère.

7. Nacelle de réticule d'une quelconque revendication précédente, ledit ou lesdits contacts de réticule mobiles comprenant quatre contacts de réticule mobiles.

8. Nacelle de réticule d'une quelconque revendication précédente, chacun desdits un ou plusieurs contacts de réticule mobiles étant opposé à l'un dudit ou desdits contacts de réticule de couvercle lorsque le couvercle vient en prise avec la plaque de base.

9. Nacelle de réticule d'une quelconque revendication précédente, chacun dudit ou desdits contacts de réticule mobiles étant décalé du ou des contacts de réticule de couvercle lorsque le couvercle vient en prise avec la plaque de base.

10. Procédé de déplacement de contacts à l'intérieur d'une nacelle, comprenant : l'activation de l'un ou de plusieurs verrous (118) situés dans une porte (104/306/404) de nacelle en fixant la porte de nacelle à un dôme (102/304/402) de nacelle ; et l'entraînement, par l'intermédiaire du ou des verrous, de l'extension de l'un ou de plusieurs montants mobiles (114/314) dans une direction comportant une composante perpendiculaire à un plan de la porte de nacelle, chacun du ou des montants mobiles entrant en contact avec un contact de réticule mobile (110/204/318) d'une plaque de base (106/320) située à l'intérieur de la porte de nacelle et du dôme de nacelle, de sorte que le contact de réticule mobile se déplace dans une direction vers un couvercle (108/322) situé à l'intérieur de la porte de nacelle et du dôme de nacelle.

11. Procédé de la revendication 10, comprenant en outre la mise en place d'un réticule sur une plaque de base de la nacelle, la jonction de la plaque de base de la nacelle à un couvercle de la nacelle, et la mise en place de la plaque de base et du couvercle joints dans un espace à l'intérieur du dôme de la nacelle.

12. Procédé de la revendication 11, ladite plaque de base et ledit couvercle joints étant en contact avec une ou plusieurs saillies provenant du dôme de nacelle lorsqu'ils sont placés à l'intérieur du dôme de nacelle.

13. Procédé de l'une quelconque des revendications 10-12, au moins trois montants mobiles étant entraînés par l'intermédiaire du ou des verrous.

14. Nacelle de réticule (100/300), comprenant : une partie interne (124/134) comprenant un couvercle (108/322) et une plaque de base (106/320), ledit couvercle comprenant un ou plusieurs contacts de réticule de couvercle (112/326) joints au couvercle et ladite plaque de base comprenant une ou plusieurs ouvertures ; et une partie externe (122/302) comprenant un dôme (102/304/402) de nacelle et une porte (104/306/404) de nacelle, ladite porte de nacelle comprenant un ou plusieurs montants mobiles (114/314) et un ou plusieurs verrous (118) conçus pour entraîner le ou les montants mobiles, lorsque la partie interne est située à l'intérieur de la partie externe et que la porte de nacelle est fixée au dôme de nacelle, ledit ou lesdits montants mobiles s'étendant à travers la ou les ouvertures dans la partie interne.

15. Procédé de fourniture de contacts à l'intérieur d'une nacelle, comprenant : l'activation de l'un ou de plusieurs verrous (118) situés dans une porte (104/306/404) de nacelle en fixant la porte de nacelle à un dôme (102/304/402) de nacelle à l'aide d'une came (308) ; et l'entraînement, par l'intermédiaire du ou des verrous ou de la came, de l'extension de l'un ou de plusieurs montants mobiles (114/314) dans une direction comportant une composante perpendiculaire à un plan de la porte de nacelle, chacun du ou des montants mobiles s'étendant à travers une plaque de base (106/320) dans une partie interne (124/324) de la nacelle lorsqu'il est entraîné par l'intermédiaire du ou des verrous ou de la came.
